# DEMANDE DE BREVET EUROPEEN

(11) **EP 2 428 487 A1**
(43) Date de publication de la demande: **14.03.2012**
(21) Numéro de dépôt: 11354042.1
(22) Date de dépôt: 30.08.2011
(51) Int. Cl.: B81C 1/00, G01P 15/125, H03H 3/007

(54) **Circuit intégré comportant un dispositif à élément mobile vertical intégré dans un substrat de support et procédé de réalisation du dispositif à élément mobile**

(30) Priorité: 10.09.2010 FR 1003633
(71) Demandeur: Commissariat à l'Énergie Atomique et aux Énergies Alternatives, 75015 Paris (FR)
(72) Inventeur: Casset, Fabrice, 38570 Tencin (FR); Cadix, Lionel, 38000 Grenoble (FR); Coudrain, Perceval, 38000 Grenoble (FR); Farcy, Alexis, 73490 La Ravoire (FR); Chapelon, Laurent-Luc, 38420 Domène (FR); Felk, Yacine 29, 08-12-2011Avully (CH); Ancey, Pascal, 38420 Revel (FR)
(74) Mandataire: Talbot, Alexandre

(57) **Abrégé**

Le circuit intégré comporte un substrat de support (1) ayant des première et seconde faces principales (2a, 2b) opposées. Une cavité traverse le substrat de support (1) et relie les première et seconde faces principales (2a, 2b). Le circuit intégré comporte un dispositif à élément mobile (5) dont l'élément mobile (6) et un couple d'électrodes (7) associées sont inclus dans une cavité. Un noeud d'ancrage de l'élément mobile (6) est localisé au niveau de la première face principale (2a). Le circuit intégré comprend une première puce (3) élémentaire disposée au niveau de la première face principale (2a) et connectée électriquement au dispositif à élément mobile (5).

## Description

### Domaine technique de l'invention

L'invention est relative à un circuit intégré comportant un substrat de support muni de première et seconde faces principales opposées et un dispositif à élément mobile intégré audit substrat de support.

L'invention est également relative à un procédé de réalisation d'un tel dispositif à élément mobile comportant un élément mobile et une électrode.

### État de la technique

Afin de poursuivre la course à la miniaturisation et à la maîtrise des coûts, les éléments discrets sont éliminés et les fonctions sont intégrées dans des puces électroniques élémentaires. Pour obtenir les fonctionnalités recherchées, de nombreuses puces élémentaires sont associées pour aboutir à une puce finale qui présente les fonctions désirées. Chaque puce élémentaire est réalisée dans une technologie qui lui est propre afin de maîtriser les coûts de production, la place occupée et/ou la puissance consommée.

Dans cette course à la miniaturisation, l'intégration qui était autrefois bidimensionnelle est devenue tridimensionnelle. Les puces élémentaires sont intégrées de part et d'autre d'un substrat de support afin de profiter de plus de surface et conserver une puce finale ayant un volume sensiblement constant.

Le remplacement des dispositifs électroniques ou mécaniques (capteurs) discrets par des composants nouveaux formés à l'intérieur des puces à permis un gain de place, mais cela s'est également traduit par une augmentation de la taille des puces élémentaires et surtout par la mise en place de procédés de réalisation complexes.

### Objet de l'invention

On constate qu'il existe un besoin de prévoir un circuit intégré qui incorpore un élément mobile associé à une puce électronique élémentaire tout en restant de taille réduite.

Pour cela, on cherche en particulier à réaliser un circuit intégré qui comporte :
- une cavité traverse le substrat de support et relie les première et seconde faces principales,
- l'élément mobile est inclus dans la cavité, l'élément mobile ayant un noeud d'ancrage au niveau de la première face principale et une zone de déplacement maximal, le noeud d'ancrage et la zone de déplacement maximal étant reliées par un axe perpendiculaire aux première et seconde faces principales,
- une première puce élémentaire est disposée au niveau d'une des faces principales et est connectée électriquement au dispositif à élément mobile.

On constate également qu'il existe un besoin de prévoir un procédé de réalisation d'un tel dispositif à élément mobile qui soit facile à mettre en oeuvre.

Le dispositif est réalisé selon un procédé comprenant les étapes suivantes :
- former un masque de gravure délimitant simultanément les dessins de l'électrode et de l'élément mobile sur une face principale d'un substrat de support,
- former, dans le substrat de support, un trou représentatif de l'électrode et un trou représentatif de l'élément mobile à partir du masque de gravure,
- former le futur élément mobile et l'électrode, dans le substrat de support,
- libérer l'élément mobile.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en vue de coupe, un circuit intégré comportant une puce élémentaire et un dispositif à élément mobile,
- la figure 2 représente, de manière schématique, en vue de dessus, le dessin d'un dispositif à élément mobile dans un masque de gravure,
- les figures 3 à 5, représentent, de manière schématique, en coupe, des étapes d'un procédé de réalisation d'une puce,
- les figures 6 à 8, représentent, de manière schématique, en coupe, des étapes d'un deuxième procédé de réalisation d'un circuit intégré,
- les figures 9 à 12, représentent, de manière schématique, en coupe, des étapes d'un troisième procédé de réalisation d'un circuit intégré,
- la figure 13 représente, de manière schématique, en coupe, une variante d'un circuit intégré avec une connexion traversante de son substrat de support.

### Description d'un mode de réalisation préférentiel de l'invention

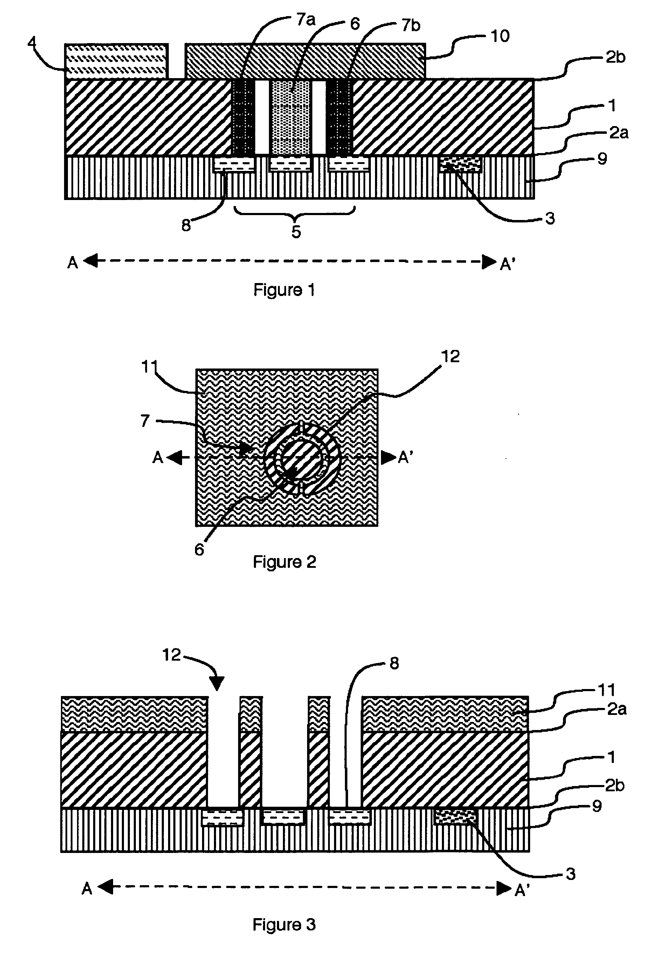

Comme cela est illustré à la figure 1, en coupe selon la direction A-A', un circuit intégré comporte un substrat de support 1 ayant des première 2a et seconde 2b faces principales opposées. Le circuit comporte une première puce électronique élémentaire 3 qui est intégrée au substrat de support 1 au niveau de sa première face principale 2a. Le circuit comporte, avantageusement, une deuxième puce électronique élémentaire 4 qui est disposée au niveau de la seconde face principale 2b du substrat de support 1. Les première 3 et deuxième 4 puces électroniques élémentaires sont séparées par le substrat de support 1.

Les puces élémentaires 3, 4 sont montées sur le substrat de support 1 qui réalise le maintien mécanique de l'ensemble. Le substrat de support 1 est par exemple une plaque d'interface sur lequel plusieurs puces élémentaires sont disposées pour former un composant plus complexe avec des fonctionnalités prédéfinies. Le substrat de support 1 est réalisé dans un matériau quelconque, par exemple en polymère, en silicium, etc... Selon les modes de réalisation, le matériau du substrat de support 1 est isolant ou conducteur électriquement voire semi-conducteur. Dans un mode de réalisation particulier, le substrat de support 1 est un substrat en silicium ou en verre. Le substrat de support peut être une puce électronique qui comporte sur une de ses faces des transistors et /ou des microsystèmes électromécaniques. La rigidité du substrat de support est fonction des applications recherchées.

Un dispositif à élément mobile 5 est formé dans le substrat de support 1. L'élément mobile 6 du dispositif 5 est formé entre les première 2a et seconde 2b faces principales. Le dispositif à élément mobile 5 peut être aligné avec les première 3 et deuxième 4 puces élémentaires dans le sens de la profondeur du substrat.

Le dispositif à élément mobile 5 comporte un élément mobile 6 et au moins une électrode 7, ici un couple d'électrodes 7 (figure 1), par exemple des électrodes d'excitation 7a et de détection 7b. L'électrode d'excitation 7a permet de faire osciller l'élément mobile 6 autour d'une position d'équilibre. L'électrode de détection 7b fournit un signal représentatif du mouvement de l'élément mobile 6.

Le dispositif à élément mobile 5 peut également comporter des moyens d'actionnement de l'élément mobile 6. Ces moyens d'actionnement peuvent être de type électrostatique comme l'électrode d'excitation 7b, mais il est également possible d'intégrer des moyens d'actionnement de type magnétique, thermique ou autre.

Le dispositif à élément mobile 5 est, par exemple, un résonateur électromécanique, une capacité variable ou un interrupteur (switch en anglais).

Le dispositif à élément mobile 5 est relié électriquement à la puce électronique 3. Selon les modes de réalisation, la puce 3 reçoit un signal représentatif du mouvement de l'élément mobile ou elle fournit un signal d'excitation à l'élément mobile 6. Il est encore envisageable que la puce 3 réalise la polarisation des différents éléments du dispositif à élément mobile 5.

La puce électronique 4 peut être reliée électriquement à la puce 3 et/ou au dispositif à élément mobile 5. La connexion électrique de la puce 4 avec les autres éléments permet d'apporter un fonctionnement plus robuste et/ou de nouvelles fonctionnalités tout en conservant un ensemble compact.

La connexion électrique peut être obtenue par différents moyens, par exemple, par des pistes électriques 8 présentes sur le substrat de support 1 ou par des pistes électriques 8 présentes sur des substrats additionnels 9 comportant les première 3 et/ou seconde 4 puces. La connexion électrique peut également être obtenue en formant le dispositif oscillant 5 directement en contact avec une des puces au moyen de plots de contact présents sur la puce.

L'intégration de l'élément mobile 6 et de sa ou ses électrodes 7 dans le substrat de support 1 permet un gain de place et une plus grande liberté dans la réalisation des puces. Il n'est plus nécessaire d'intégrer un dispositif à élément mobile discret à la surface du substrat de support 1, ni d'intégrer le dispositif à élément mobile 5 dans une puce au-dessus des transistors.

Cette architecture permet de former des éléments mobiles de grandes dimensions car ils sont réalisés dans le substrat. Ceci autorise la formation d'un élément mobile servant de base de temps tout en présentant de très bonnes performances et un encombrement réduit. Cela permet encore de former des capacités variables dans des gammes de valeurs importantes car elles dépendent des surfaces de l'élément mobile. Il est encore possible de former un interrupteur fonctionnant avec des tensions peu courantes car la valeur de la tension de commande est liée aux dimensions de l'élément mobile. Cette architecture autorise la formation d'éléments mobiles dans des gammes de dimensions très importantes, par exemple dont l'épaisseur et/ou la largeur présentent des dimensions nanométriques jusqu'à micrométriques.

L'élément mobile 6 et sa ou ses électrodes 7 associées sont disposés dans une cavité fermée, de préférence une cavité étanche. La cavité présente des parois latérales formées par le substrat de support 1. Si la cavité est de section cylindrique, la cavité ne présente qu'une paroi latérale assimilée à plusieurs parois latérales. Les parois latérales proviennent d'un trou formé dans le substrat de support 1 qui traverse le substrat de support 1, ici un trou formé depuis la face principale 2b jusqu'à la face principale 2a. La cavité relie les première 2a et seconde 2b faces principales.

La cavité est fermée par des bouchons de fermeture 10. Des premier et second bouchons de fermeture sont présents sur les première 2a et seconde 2b faces principales du substrat de support 1. Dans certains modes de réalisation, les bouchons de fermeture sont formés par les substrats additionnels 9 comportant une puce électronique (figure 1).

La cavité est délimitée par des première et seconde parois principales opposées qui sont situées au niveau des première 2a et seconde 2b faces principales du substrat de support 1 et qui ferment la cavité. Ainsi, les première et seconde parois principales sont séparées par le substrat de support 1. Les première et seconde parois principales sont séparées par l'élément mobile 6 et les électrodes 7.

Un noeud d'ancrage, également appelé noeud d'encatrement, de l'élément mobile 6 est disposé au niveau d'une des faces principales du substrat de support 1 au moyen d'un des bouchons de fermeture 10. En d'autres termes, une des parois principales de la cavité comporte un noeud d'ancrage de l'élément mobile 6.

Les pistes électriques 8 traversent les bouchons de fermeture afin de permettre le fonctionnement du dispositif oscillant 5. Ceci permet de définir les différentes polarisations, d'apporter le signal d'excitation et/ou de récupérer un signal de détection. La cavité est limitée au volume nécessaire à l'élément mobile 6 et sa ou ses électrodes associées 7. Les autres composants du dispositif à élément mobile comme, par exemple, une boucle de réaction sont disposés hors de la cavité.

Dans un mode de réalisation préférentiel, le gain en compacité dans le dispositif passe également par l'utilisation d'un dispositif à élément mobile 5 formé selon une architecture verticale au lieu d'une architecture horizontale. Dans cette architecture verticale, l'élément mobile 6 présente un noeud d'ancrage au niveau d'une des faces principales et il est orienté perpendiculairement à la première face principale du substrat de support 1 en direction de la seconde face principale. Ainsi, l'élément mobile 6 est formé à l'intérieur du substrat de support. L'élément mobile 6 présente au moins une zone de déplacement nul représentée par le noeud d'ancrage et une zone de déplacement maximal, c'est-à-dire la zone de l'élément mobile la plus éloignée de sa position à l'équilibre. Selon les modes de réalisation et le mouvement imprimé à l'élément mobile 6, cette zone de déplacement maximal peut se trouver à un endroit quelconque de l'élément mobile.

Dans l'architecture verticale, la zone de déplacement maximal de l'élément mobile se déplace dans un plan perpendiculaire, ou sensiblement perpendiculaire, à l'axe reliant cette zone au noeud d'ancrage. Dans ce mode de réalisation, la zone de déplacement maximal est comprise dans un plan parallèle à la première face principale ou parallèle aux deux faces principales. A titre d'exemple, dans une architecture à simple encastrement, la zone de déplacement maximal peut être située à l'extrémité opposée à la zone d'encastrement. Dans une architecture de type encastrée-encastrée, la zone de déplacement maximal peut être située entre les deux noeuds d'encastrement, de préférence à équidistance des noeuds.

Les faces en regard de l'élément mobile 6 et des électrodes 7 associées sont perpendiculaires à la première face principale. Ces faces en regard représentent la majeure partie de la surface de l'élément mobile 6. Les faces en regard de l'élément mobile 6 et de la ou des électrodes 7 associées sont comprises entre les parois principales 2a et 2b du substrat de support 1.

Cette orientation verticale de l'élément mobile 6 et des électrodes 7 permet de profiter d'un élément mobile de grande dimension tout en limitant la surface occupée sur les faces principales du substrat de support 2.

Le dispositif à élément mobile ayant une architecture verticale, la majeure partie de la surface interne de la cavité est formée par ses parois latérales. La pollution de l'atmosphère interne depuis l'extérieure est limitée grâce aux faibles surfaces représentées par les bouchons de fermetures 10. Les parois latérales étant usinées dans le substrat de support 1, cela permet de limiter les risques de désorption et ainsi d'assurer une atmosphère de meilleure qualité dans la cavité. Ceci est particulièrement efficace lorsque le substrat de support est en silicium et plus particulièrement en silicium monocristallin

Par ailleurs, la formation de la cavité dans le matériau de support assure une certaine rigidité mécanique, c'est-à-dire une protection accrue contre les chocs et donc un fonctionnement sûr du dispositif à élément mobile 5.

De manière préférentielle, l'élément mobile 6 présente un axe de symétrie et/ou un plan de symétrie qui est perpendiculaire à la première face principale. De manière encore plus préférentielle, le dispositif à élément mobile 5 présente un axe de symétrie et/ou un plan de symétrie perpendiculaire à la première face principale. Ceci permet de mieux contrôler le fonctionnement du dispositif à élément mobile.

Lorsque l'élément mobile 6 est de type simple encastrement (cantilever), le noeud d'ancrage est formé au niveau de la première face principale ou au niveau de la seconde face principale. L'axe reliant le noeud d'ancrage à l'extrémité libre de la poutre est perpendiculaire à la face principale contenant l'ancrage. Si l'élément mobile 6 est de type double encastrement, un premier point d'ancrage est formé au niveau de la première face principale et un second point d'ancrage est formé sur la seconde face principale. L'axe reliant les deux points d'ancrage est perpendiculaire aux faces principales. Dans la mesure où les déformations sont faibles, l'axe reliant la zone de déplacement maximal au noeud d'encastrement est considéré comme restant perpendiculaire à la face principale contenant le noeud d'ancrage.

Dans un premier mode de réalisation, la longueur de l'élément mobile 6 est égale à l'épaisseur du substrat de support 1. Dans une variante de réalisation, la longueur de l'élément mobile 6 est inférieure à l'épaisseur du substrat de support 1. Cette modification de la longueur permet par exemple de changer la fréquence de résonance du dispositif. Le raccourcissement de l'élément mobile 6 peut être réalisé par toute technique adaptée, par exemple par gravure plasma.

Dans un mode de réalisation préférentiel, la longueur des électrodes 7 est égale à l'épaisseur du substrat de support. Il est également envisageable de réduire la longueur des électrodes 7.

Dans un autre mode de réalisation avantageux, la longueur de l'élément mobile 6 et des électrodes 7 sont identiques, ce qui permet une meilleure détection ou excitation de l'élément mobile. Cet avantage provient de la définition des électrodes au moyen de trous dans le substrat de support 1.

Dans un mode de réalisation particulier, une partie de la cavité est délimitée par les électrodes 7 qui sont en contact direct avec le substrat de support 1. De cette manière, les électrodes 7 sont collées au substrat de support 1. Ce mode de réalisation est particulièrement avantageux dans une architecture verticale où les électrodes présentent une longueur très importante. Ce mode de réalisation particulier permet de réduire les risques de déformation des électrodes et donc l'évolution des performances du dispositif dans le temps.

De manière générale, le procédé comporte la formation d'un masque de gravure 11 sur une des faces principales 2 du substrat de support 1, comme cela est illustré aux figures 2 et 3. Le masque de gravure 11 comporte le dessin d'au moins une des électrodes 7 et de son élément mobile 6. Le masque de gravure 11 peut être une couche en résine provenant d'une étape de photolithographie ou un masque de gravure intermédiaire, également appelé masque dur, par exemple en matériau diélectrique isolant. Le dessin du masque de gravure intermédiaire provient du dessin du masque de gravure initial.

La figure 2 illustre, en vue de dessus, le dessin du masque de gravure 11 et les trous en découlant à l'intérieur du substrat de support. La figure 2 indique également l'axe A-A' représentatif des autres figures.

Comme cela est illustré à la figure 3 en coupe selon l'axe A-A', des trous 12 représentatifs des électrodes 7a, 7b et de l'élément mobile 6 sont formés dans le substrat de support 1. De manière préférentielle, les trous représentatifs de l'élément mobile 6 et des électrodes 7 sont formés simultanément, mais il est également envisageable de les former l'un après l'autre. Les trous 12 sont formés au moyen du masque de gravure 11 par toute technique adaptée, par exemple par une gravure plasma. Comme indiqué précédemment, il est possible de ne former qu'une seule électrode 7.

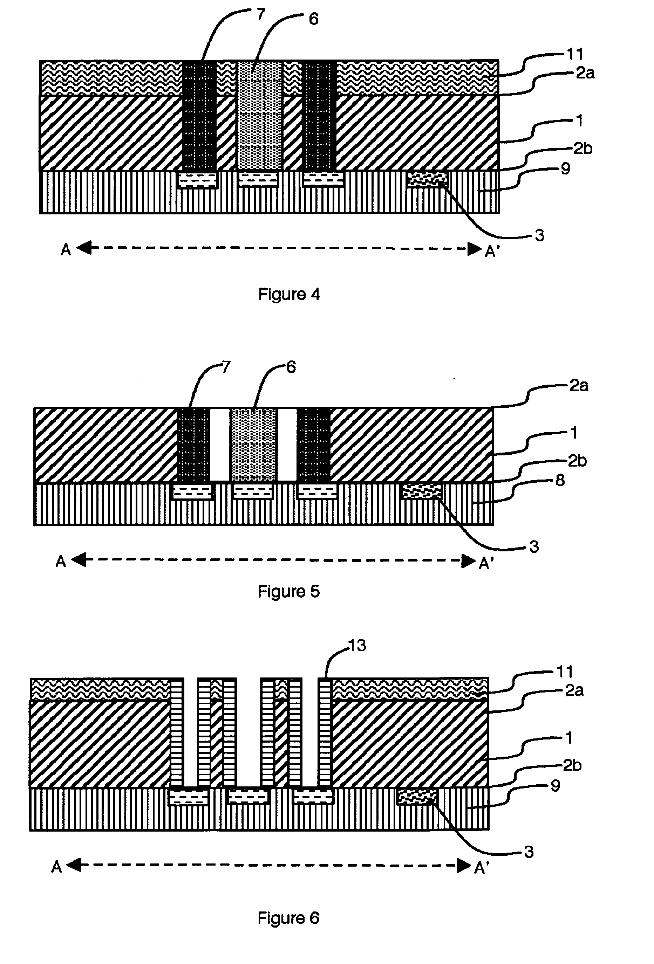

Comme cela est illustré à la figure 4, les trous 12 sont ensuite remplis, par un matériau électriquement conducteur, afin de former l'élément mobile 6 et l'électrode 7 dans le substrat de support 1.

Comme cela est illustré à la figure 5, une partie du substrat de support 1 est ensuite éliminée pour libérer l'élément mobile 6. Une des extrémités de l'élément mobile 6 est encastrée avant l'étape de libération. Le masque de gravure 11 a également été éliminé pour atteindre le substrat de support 1.

Selon les procédés de réalisation employés, il est possible d'éliminer le masque de gravure 11 après avoir formé les trous ou lors de la localisation du matériau électriquement conducteur dans les trous 12. Il est également possible de le garder dans le dispositif final.

Un bouchon de fermeture 10 est ensuite disposé sur la face libre du substrat de support afin de fermer la cavité comme cela est illustré à la figure 1.

De manière préférentielle, le masque de gravure 11 comporte le dessin de l'élément mobile 6 et du couple d'électrodes 7 auquel il est associé. Dans une variante de réalisation, le masque de gravure 11 comporte les dessins d'autres composants du dispositif à élément mobile 5 ou d'autres éléments traversant le substrat de support 1 (comme des interconnexions). Le dessin de l'élément mobile 6 et des électrodes 7 est représenté par des zones vides du masque de gravure 11.

Les caractéristiques de fonctionnement du dispositif à élément mobile 5 sont liées, en partie, aux matériaux employés et aux dimensions des trous. Dans un mode de réalisation particulier illustré aux figures 1, 4 et 5, un premier matériau conducteur est utilisé pour former l'élément mobile 6 et un second matériau conducteur est utilisé pour former les électrodes 7. Cette différenciation permet d'obtenir de bonnes performances électriques pour les électrodes 7 et les performances mécaniques recherchées pour l'élément mobile 6. Cependant, l'utilisation du même matériau électriquement conducteur permet de faciliter le procédé de réalisation.

Dans un premier mode de réalisation particulier illustré à la figure 3, la puce 3 est formée au niveau d'un substrat 9. De manière préférentielle, la puce 3 est formée dans un substrat semi-conducteur. La puce 3 comporte une ou plusieurs pistes électriques 8 courant sur le substrat 9 et servant à l'alimentation du dispositif à élément mobile 5 à venir. La puce 3 et les pistes électriques 8 peuvent être découvertes ou recouvertes par un film de passivation. Les pistes électriques 8 sont formées par un matériau électriquement conducteur comme un métal ou un matériau semi-conducteur dopé. Il est également envisageable de former la puce 3 sur un autre substrat et ensuite de l'intégrer au substrat additionnel 9.

Le substrat 9 est collé au substrat de support 1 en recouvrant et protégeant la puce 3 et les pistes électriques 8.

Dans un mode de réalisation particulier, le substrat 9 est aminci après avoir été collé au substrat de support 1.

Une pluralité de trous 12 est formée dans le substrat de support 1 depuis la seconde face principale. Les trous 12 vont définir, dans le substrat de support 1, la forme d'un futur élément mobile 6, de son électrode ou de ses électrodes associées, par exemple des électrodes d'excitation 7a et de détection 7b.

Les trous 12 traversent le substrat de support 1 afin de découvrir la ou les pistes électriques 8 du substrat 9. Les trous 12 sont définis à partir d'une étape de photolithographie suivie d'une étape de gravure. A titre d'exemple, pour un résonateur électromécanique, la longueur est égale à 50µm, la largeur est comprise entre 1 µm et quelques dizaines de micromètres.

De ce fait, les trous 12 traversent complètement le substrat de support 1, mais s'arrêtent dans le substrat 9 ou à la surface du substrat 9. La forme des trous 12 définit la forme de l'élément mobile 6 et de ses électrodes 7 associées. La profondeur des trous, c'est-à-dire l'épaisseur du substrat définit la longueur des électrodes 7 et de l'élément mobile 6. La distance entre les trous définit l'espacement (l'entrefer) entre l'élément mobile 6 et son électrode d'excitation 7a ou entre l'élément mobile 6 et son électrode de détection 7b. L'élément mobile 6 et les électrodes 7 étant définis simultanément dans la même étape photolithographique, cela permet d'obtenir un auto-alignement de l'élément mobile 6 par rapport à ses électrodes 7 associées.

Dans un mode de réalisation particulier illustré à la figure 6, en coupe selon l'axe A-A' de la figure 3, le substrat de support 1 est électriquement conducteur. Afin d'éviter tout court-circuit entre les différents éléments du dispositif à élément mobile 5, une couche 13 en matériau électriquement isolant est déposée sur les parois latérales des trous 12. L'épaisseur de la couche 13 électriquement isolante permet de définir et/ou de corriger la largeur et l'épaisseur de l'élément mobile 6 et de ses électrodes 7 à partir de ce qui a été défini par photolithographie.

Il est également envisageable de différencier l'épaisseur et la nature du matériau isolant formé dans les différents trous 12. Cette différenciation permet de moduler les dimensions des différentes électrodes 7 et de l'élément mobile 6. Cela permet également de moduler l'entrefer.

Cette souplesse de réalisation n'est pas possible lorsque les électrodes 7 et l'élément mobile 6 sont formés directement par gravure du matériau conducteur.

La couche 13 électriquement isolante peut être réalisée par toute technique adaptée, par exemple par oxydation des matériaux présents ou par dépôt d'un matériau électriquement isolant. De manière préférentielle, la couche 13 électriquement isolante est déposée à basse température, par exemple par dépôt chimique en phase vapeur assisté par plasma, afin de limiter le budget thermique imposé à la puce 3. A titre d'exemple la couche isolante est un oxyde de silicium dont l'épaisseur est comprise entre 50 et 200nm. Le matériau de la couche 13 électriquement isolante est avantageusement choisi pour limiter les pertes et les capacités parasites à l'intérieur du dispositif.

Même si le substrat 1 n'est pas électriquement conducteur, il est avantageux d'utiliser la couche 13 dans un matériau qui peut être sacrificiel afin de maîtriser les caractéristiques dimensionnelles du dispositif.

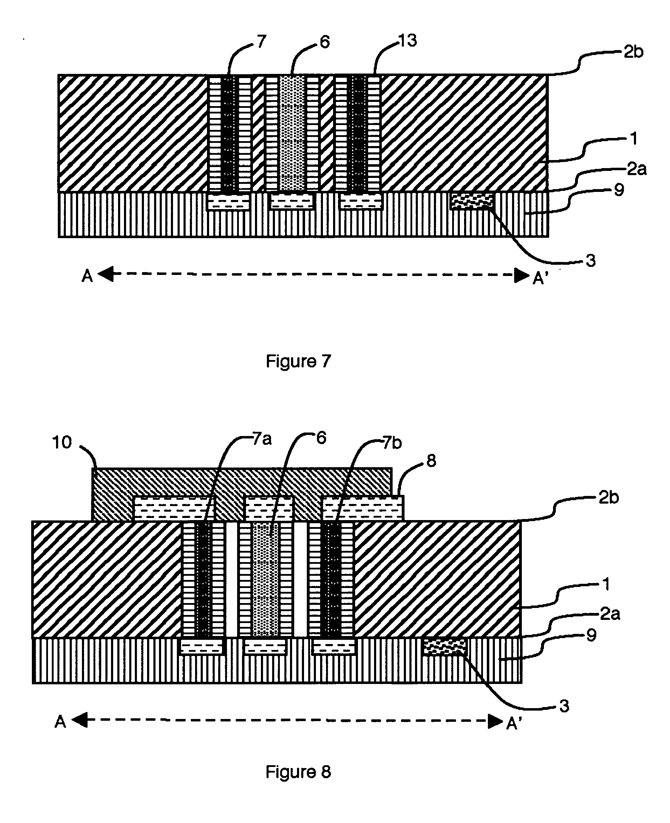

Comme cela est illustré à la figure 7, les trous 12 sont ensuite remplis par un matériau électriquement conducteur comme un métal ou un matériau semi-conducteur dopé. A ce moment, les électrodes 7 sont formées ainsi que le futur élément mobile 6. La localisation du matériau électriquement conducteur est réalisée par tout moyen adapté, par exemple au moyen d'une étape de polissage mécano-chimique et/ou d'une étape de gravure plasma.

Dans un mode de réalisation préférentiel, si le matériau conducteur déposé dans les trous 12 est un métal et si les pistes électriques 8 sont en matériau semi-conducteur dopé, il est avantageux de réaliser une étape de siliciuration des pistes électriques 8 avant de déposer le métal. Cette siliciuration permet d'obtenir des meilleures propriétés électriques.

Cette siliciuration est également avantageuse en ce qui concerne l'élément mobile 6 car cela permet d'obtenir de meilleures propriétés mécaniques.

Selon les modes de réalisation employés, une fois que l'élément mobile 6 et ses électrodes 7 associées sont formées, il est possible de former sur la seconde face principale du substrat de support 1 un second point d'encastrement de l'élément mobile 6. L'élément 6 est alors du type encastrée-encastrée. Cet encastrement supplémentaire peut être formé, par exemple, par une seconde piste électrique 8 comme cela est illustré à la figure 8

II est également possible de former, sur la seconde face principale, de nouvelles pistes électriques 8 reliées uniquement aux électrodes 7 de détection et/ou d'excitation.

L'élément mobile 6 est ensuite libéré en éliminant le matériau du substrat de support 1 qui se trouve entre l'élément mobile 6 et l'électrode d'excitation 7a et le matériau qui se trouve entre l'élément mobile 6 et l'électrode de détection 7b. Un bouchon de fermeture 10 est ensuite déposé pour fermer la cavité comme cela est illustré à la figure 8.

Par la suite, la puce électronique 4 peut être montée sur le substrat de support 1 pour coopérer avec la puce 3 et/ou l'élément oscillant 5 ou pour assurer une autre fonction.

Dans une variante de réalisation non représentée, le substrat 9 ne comporte pas de pistes électriques 8 et l'alimentation du dispositif à élément mobile 5 est réalisée à partir de la seconde face principale du substrat de support 1. Le substrat 9 comporte la puce 4 et la puce 3 est montée par la suite sur l'autre face du substrat de support 1.

Dans encore une autre variante de réalisation non représentée, les pistes électriques 8, reliées au dispositif à élément mobile 5, sont présentes en partie sur la première face principale et en partie sur la seconde face principale du substrat de support 1.

Dans un second mode de réalisation, la puce 3 est formée sur la face principale 2a du substrat 9 qui joue le rôle du substrat de support 1.

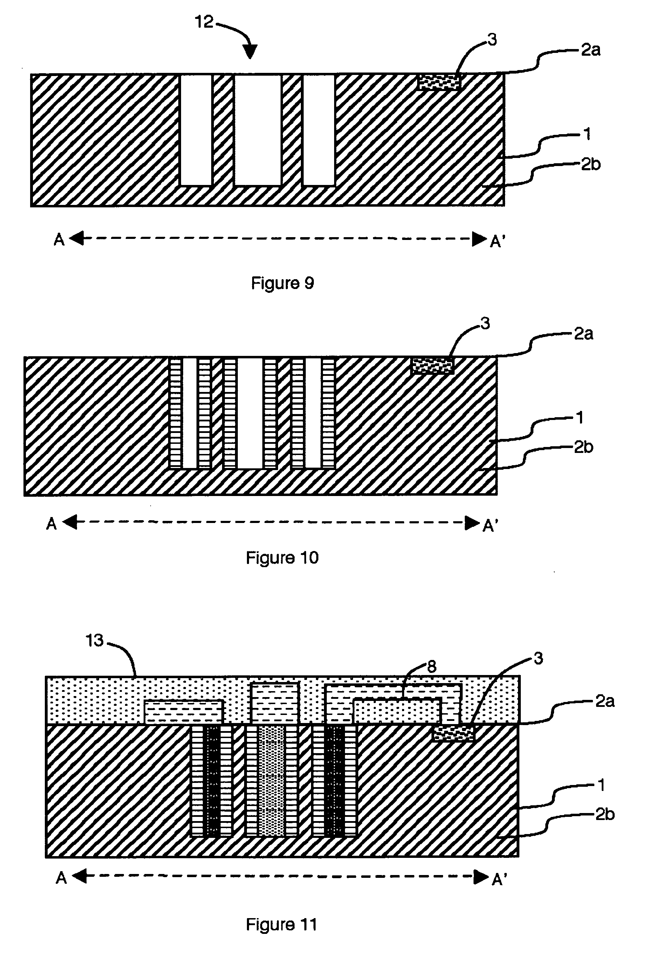

Comme cela est illustré à la figure 9 en coupe selon l'axe A-A' de la figure 2, une pluralité de trous 12 est formée dans le substrat de support 1 à partir de la face principale 2a. Comme précédemment, les trous 12 définissent l'élément mobile 6 et ses électrodes 7 associées. Comme précédemment, les trous 12 sont formés à partir du masque de gravure 11 qui a été éliminé à la figure 9.

Selon les modes de réalisation utilisés, les trous peuvent traverser ou s'arrêter dans le substrat de support 1. Si les trous traversent le substrat de support 1 (mode de réalisation non représenté), il est avantageux de former sur une des faces principales un motif de recouvrement qui bouche le fond des trous 12.

Comme dans le mode de réalisation précédent, si le substrat de support 1 est électriquement conducteur, une couche 13 d'isolation électrique est formée sur les parois latérales afin d'assurer une indépendance électrique des différents composants, comme cela est représenté à la figure 10. De manière avantageuse, la couche 13 d'isolation électrique est également utilisée même si le substrat de support est électriquement isolant pour limiter les pertes et les capacités parasites.

Comme dans le mode de réalisation précédent, les trous 12 sont remplis par un matériau électriquement conducteur pour former la ou les électrodes 7 et le futur élément mobile 6.

Comme cela est illustré à la figure 11, les pistes électriques 8 d'alimentation du dispositif à élément mobile 5 sont formées sur une face principale du substrat de support 1, ici la première face 2a. Les pistes électriques 8 sont formées par toute technique adaptée, par exemple au moyen du dépôt et de la gravure d'un matériau électriquement conducteur. Cependant, il est également possible de former les pistes électriques dans les niveaux d'interconnexions métalliques de la première puce 3 (figure 11).

Dans un mode de réalisation particulier, un premier point d'encastrement est formé sur la première face principale.

De manière avantageuse, la première face principale du substrat de support 1 est ensuite recouverte par une couche de passivation 13 qui forme un bouchon de fermeture.

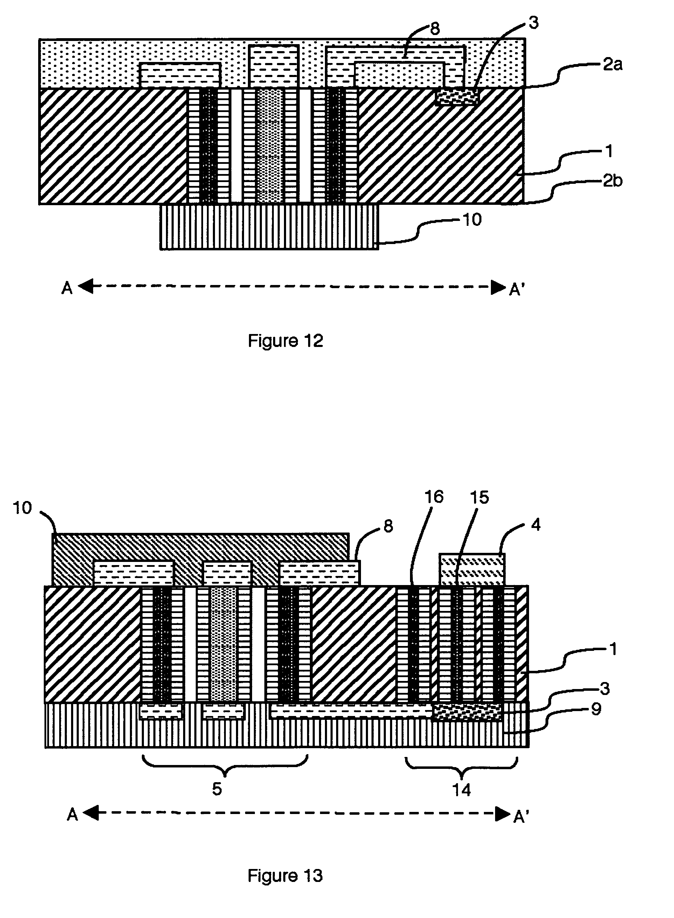

Comme illustré à la figure 12, les trous 12 qui ont été remplis par le matériau électriquement conducteur sont alors découverts au niveau de leur fond. Si un motif de recouvrement a été utilisé, ce dernier est éliminé. Si les trous 12 ne traversent pas le substrat de support 1, c'est-à-dire que l'on est en présence de trous 12 borgnes, la seconde face principale est gravée afin de découvrir le futur élément mobile 6 et ses électrodes 7 associées.

La gravure de la seconde face principale du substrat de support 1 ou le retrait du motif de recouvrement 10 peut être effectué par tout moyen, par exemple par gravure plasma ou par voie humide ou au moyen d'une étape de polissage mécano-chimique.

Une fois les électrodes 7 et l'élément mobile 6 partiellement découverts, le matériau du substrat de support 1 est éliminé entre l'élément mobile et ses électrodes 7 associées ce qui a pour effet de libérer l'élément mobile 6.

La seconde face principale est ensuite recouverte par un bouchon de fermeture qui peut être un nouveau motif de recouvrement. Selon les modes de réalisation employés, le bouchon de fermeture 10 forme ou non un second point d'encastrement sur la seconde face principale.

Comme dans le mode de réalisation précédent, il est possible de différencier le matériau formant l'élément mobile 6 de celui formant les électrodes 7.

Ce second mode de réalisation est particulièrement avantageux car il permet de réaliser le dispositif à élément mobile 5 dans le substrat semi-conducteur sur lequel est formée la première puce. Ainsi, le dispositif à élément mobile 5 est formé au plus près des éléments actifs de la première puce ce qui permet de réduire les capacités et résistances parasites.

La définition de la forme de l'élément mobile 6 et de ses électrodes 7 lors d'une même étape de photolithographie permet d'obtenir un autoalignement de ces éléments. Cet autoalignement permet notamment de réduire les contraintes d'alignement imposées aux différentes étapes de photolithographie utilisées. Cela permet également d'assurer que l'entrefer entre l'élément mobile 6 et ses électrodes 7 associées est constant et/ou maîtrisé.

Comme il est possible de réaliser un traitement séparé des différents trous en ce qui concerne la nature des matériaux déposés et les épaisseurs désirées, ce procédé de réalisation apporte un levier supplémentaire de différenciation entre plusieurs dispositifs à élément mobile formés dans le substrat de support 1. Il est alors possible d'obtenir des dispositifs à élément mobile présentant des caractéristiques différentes d'entrefer et/ou de raideur sans changer le masque photolithographique, ni les conditions d'exposition et de développement.

Comme l'élément mobile 6 est intégré dans le volume du substrat de support 1 selon une architecture verticale, le dispositif à élément mobile 5 occupe très peu de place dans le dispositif final. Ceci permet d'intégrer, dans un mode de réalisation particulier, au moins une puce sur chaque face principale et le dispositif à élément mobile 5 entre les deux puces. Cette organisation particulière permet également de réaliser des connexions électriques 14 à travers le substrat de support 1 sans être gêné par le dispositif à élément mobile 5.

Le circuit comporte alors une puce 3 disposée sur une première face principale d'un substrat de support 1, une puce 4 disposée sur une seconde face principale d'un substrat de support 1. Il comporte également un dispositif à élément mobile 5 disposé dans le substrat de support 1. Il comporte encore une connexion électrique 14 reliant la première face principale à la seconde face principale et traversant le substrat de support 1. Cette connexion électrique 14 peut connecter électriquement la puce 3 à la puce 4 (figure 13 en coupe) ou réaliser la connexion électrique entre une source d'alimentation et une puce disposée sur une face opposée.

De manière avantageuse, la connexion électrique 14 traversant le substrat de support 1 est formée simultanément au dispositif à élément mobile 5. De manière encore plus avantageuse, la connexion électrique traversante est dite coaxiale. Cette connexion particulière comporte une âme 15 électriquement conductrice séparée d'une gaine 16 électriquement conductrice par un matériau électriquement isolant. L'âme et la gaine sont coaxiales. Dans le cas présent, un anneau en substrat de support, également coaxial, sépare la gaine 16 de l'âme 15. Cet anneau est lui-même séparé de l'âme 15 et de la gaine 16 par une couche en matériau électriquement isolant en forme d'anneau.

Afin de faciliter la réalisation de cette structure, le masque de gravure comporte le dessin du dispositif à élément mobile 5 et celui de la connexion électrique traversante 14. Le dessin représente un disque ou un disque entouré par un anneau de préférence coaxial. Le procédé de réalisation est identique à ce qui a été décrit précédemment, mais il n'est pas nécessaire d'éliminer le matériau du substrat 1 à l'intérieur de la gaine 16. Dans une variante de réalisation, le matériau du substrat 1 est éliminé pour former une connexion à cavité d'air.

La connexion avec une puce peut être obtenue en débouchant directement sur une puce ou au moyen de pistes électriques 8.

Le matériau électriquement conducteur formant l'âme 15, la gaine 16, les électrodes 7 et l'élément mobile 6 est, par exemple, choisi parmi le cuivre, l'or ou le polysilicium dopé. La distance entre la gaine 16 et l'âme 15 est avantageusement comprise entre 50 et 100nm pour les valeurs les plus basses. Cependant, des valeurs plus élevées sont possibles selon les besoins.

L'épaisseur de l'élément mobile 6 et le diamètre de l'âme 15 sont avantageusement compris entre 1 et 5µm. L'épaisseur du substrat de support 1 est avantageusement comprise entre 15 et 50µm ce qui correspond à une longueur d'élément mobile 6 particulièrement intéressante.

Le dispositif à élément mobile 5 permet de former un résonateur électromécanique s'il est associé à une boucle de contre-réaction. A titre d'exemple, il est également possible de former une capacité variable en déplaçant l'élément mobile 6 par rapport aux électrodes 7. Il est encore possible de former un interrupteur en autorisant le contact électrique entre l'élément mobile 6 et une des électrodes 7, l'élément mobile 6 étant déplacé au moyen d'une électrode de commande.

## Revendications

1. Circuit intégré comportant un substrat de support (1) muni de première et seconde faces principales (2a, 2b) opposées et un dispositif à élément mobile intégré audit substrat de support, circuit **caractérisé en ce que** :
- une cavité traverse le substrat de support (1) et relie les première et seconde faces principales (2a, 2b),
- l'élément mobile (6) est inclus dans la cavité, l'élément mobile (6) ayant un noeud d'ancrage au niveau de la première face principale (2a) et une zone de déplacement maximal, le noeud d'ancrage et la zone de déplacement maximal étant reliés par un axe perpendiculaire aux première et seconde faces principales (2a, 2b),
- au moins une puce (3) élémentaire est disposée au niveau d'une des faces principales (2a, 2b) et est connectée électriquement au dispositif à élément mobile (5).

2. Circuit selon la revendication 1, **caractérisé en ce qu'**il comporte des moyens d'actionnement de l'élément mobile (6) inclus dans la cavité.

3. Circuit selon la revendication 2, **caractérisé en ce que** les moyens d'actionnement sont de type électrostatique et comporte un couple d'électrodes (7) en vis-à-vis dont une est disposée sur l'élément mobile (6).

4. Circuit selon l'une quelconque des revendications 1 à 3, **caractérisé en ce qu'**il comporte un second noeud d'ancrage de l'élément mobile (6) au niveau de la deuxième face principale opposée (2b).

5. Circuit selon l'une quelconque des revendications 1 à 4, **caractérisé en ce que** la puce (3) est formée dans le substrat de support (1) en matériau semi-conducteur.

6. Circuit selon l'une quelconque des revendications 1 à 5, **caractérisé en ce que** la puce (3) élémentaire comporte une connexion électrique (14) traversant le substrat de support (1).

7. Procédé de réalisation d'un dispositif à élément mobile (5) comportant un élément mobile (6) et une électrode (7) **caractérisé en ce qu'**il comporte les étapes suivantes :
- former un masque de gravure (11) délimitant simultanément les dessins de l'électrode (7) et de l'élément mobile (6) sur une face principale (2) d'un substrat de support (1),
- former, dans le substrat de support (1), un trou (12) représentatif de l'électrode (7) et un trou (12) représentatif de l'élément mobile (6) à partir du masque de gravure (11),
- former le futur élément mobile (6) et l'électrode (7), dans le substrat de support (1),
- libérer l'élément mobile (6),
- prévoir une puce (3) élémentaire disposée au niveau d'une des faces principales (2a, 2b) et connectée électriquement au dispositif à élément mobile (5).

8. Procédé selon la revendication 7 **caractérisé en ce que** le masque de gravure (11) comporte le dessin d'un couple d'électrodes (7).

9. Procédé selon l'une des revendications 7 et 8, **caractérisé en ce qu'**un point d'encastrement de l'élément mobile (6) est réalisé, après avoir formé l'élément mobile (6).

10. Procédé selon l'une quelconque des revendications 7 à 9, **caractérisé en ce que** le masque de gravure (11) comporte le dessin d'une connexion électrique (14) entre des première (2a) et seconde (2b) faces principales opposées d'un substrat de support (1), la connexion électrique (14) traversant le substrat de support (1).

11. Procédé selon l'une quelconque des revendications 7 à 10, **caractérisé en ce qu'**il comporte l'amincissement du substrat de support (1) pour découvrir une partie de l'élément mobile (6) et de l'électrode (7).

12. Procédé selon l'une quelconque des revendications 7 à 11, **caractérisé en ce que** le trou (12) représentatif de l'électrode (7) et le trou (12) représentatif de l'élément mobile (6) traversent le substrat de support (1).
